Europäisches Patentamt

European Patent Office

Office européen des brevets

(11) Publication number: **0 156 298**
**B1**

## EUROPEAN PATENT SPECIFICATION

(45) Date of publication of patent specification: **05.10.88**

(51) Int. Cl.⁴: **H 05 K 7/14**

(21) Application number: **85103226.8**

(22) Date of filing: **20.03.85**

(54) Rack housing for user reconfigurable EDP system.

(30) Priority: **28.03.84 IT 2025884**

(43) Date of publication of application:
**02.10.85 Bulletin 85/40**

(45) Publication of the grant of the patent:
**05.10.88 Bulletin 88/40**

(84) Designated Contracting States:
**DE FR GB IT**

(56) References cited:
**BE-A- 873 449**
**GB-A-1 508 832**
**US-A-4 301 494**
**US-A-4 334 261**

(73) Proprietor: **HONEYWELL BULL ITALIA S.p.A.**
**Via Martiri d'Italia 10**
**I-10014 Caluso (TO) (IT)**

(72) Inventor: **De Andrea, Renato**
**Via Maniago 21**
**I-20134 Milano (IT)**

Courier Press, Leamington Spa, England.

## Description

The present invention relates to rack housing for user reconfigurable EDP system.

Modern data processing systems are constituted by electronic circuits mounted on a plurality of printed circuit boards (for the following identified with PWA that is "Printed Wired Artwork") housed in a box shaped frame having an open forehead and arranged therein on suitable parallel tracks.

The tracks constitute a rack for the mechanical positioning of the several PWAs.

The PWA, singly or in sets, carry out the function of system central unit and of peripheral unit controllers.

The frame forehead is open to allow the insertion of the several PWAs on the tracks and may be closed by a cover fixed by screws or by other fixing means such as the so-called "fasteners".

Modern data processing systems are reconfigurable, that is allow to increase their performances and meet the specific needs of the user by the addition of electronic circuits.

This is made with the addition of PWAs in the frame.

To this purpose the frame is intended to contain a prefixed number of PWAs while the actually inserted PWAs vary from a minimum $M<N$ up to N according to the specific needs of the user.

The minimum number M of PWAs constitutes the minimum system configuration, that is a set of electronic circuits which may be tested and which is able to operate in a correct way according to minimum user requirements.

In the conventional manufacturing and distribution of such requirements the warehouse administration is affected by important cost problems. There are two approaches which may be followed.

According to a first approach the EDP systems are assembled in their minimum configuration, tested and packed, in order to be ready for the distribution, than stored.

The system reconfiguration, according to the user needs, is performed at the user site by specialized technical people which adds PWAs to the system.

The cost of the specialized operation is high and does not conform to the technological trends of supplying products of the "plug" and play" type which do not require a specialized technical support for their installation.

According to a second approach the EDP systems are assembled in any possible configuration, tested, packed and stored.

In this case a configured model suitable for any user need is available, but this causes an high increase of the fixed store investments. Besides, in case the user needs evolve, the already installed system must be substituted or the specialized operation is again required. To overcome such inconvenient the embodiment has been recently suggested of systems where the reconfiguration can be performed by the user himself once provided with a system with the minimum configuration and the necessary additional PWAs.

The reconfiguration operation must be easy, must not require particular devices and constructive complications which may increase the cost of the product and, especially, the removal and the damaging of the already installed PWAs owing to an uncareful handling must be avoided.

It is known in the art, for instance from US Patents 4,334,261 and 4,301,494, that the open forehead of a rack housing for several PWAs can be closed by a plurality of cover plates, one for each PWA, fixed by knurled grips or fasteners.

This solution may undergo possible system reconfigurations effected by users, but the equipment assembling becomes longer and more complicated therefore causing a cost increase if compared with the cost of a similar equipment provided with a single cover for the whole rack housing.

In both the cases the user is not prevented from removing the already installed PWAs.

Further the repetitive modularity of the cover plates described in the already mentioned patents can mislead the user in the reconfigurating operation.

Such inconvenients are overcome by the rack housing for user reconfigurable system object of the present invention as claimed where the open housing front is closed by a single cover, easy to be removed by the user, or by a plurality of covers each of them however covering a plurality of printed circuit boards and providing the selective access to preestablished housing rails and where removal of the printed circuit boards arranged on the remaining rails is prevented by a protection and stopping bar.

The protection bar is provided with suitable cutout portions in correspondence of the housing positions where the selective introduction of printed circuit boards is allowed and it is interposed between the frame and the cover so that its removal requires the cover removal.

It is fixed to the frame by means of screws different from the ones fixing the cover so that the cover removal does not involve the bar removal.

Further the screws fixing the bar to the frame are of a kind requiring the use of a tool and they are preferably masked by the cover.

In this way a double protection is assured because any accidental removal of the bar without the previous cover removal is prevented.

These and other features of the invention will appear clearly from the following description of a preferred form of embodiment and from the enclosed drawing where:

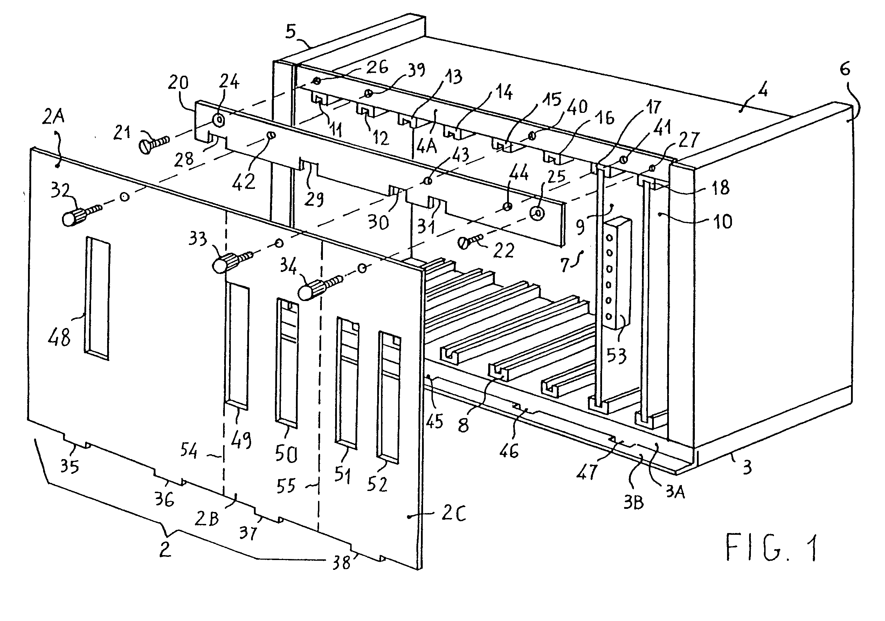

Figure 1 shows in exploded perspective view a preferred embodiment of the invention.

With reference to Fig. 1 the rack housing of the invention consists of a box constituted by a rigid frame and a front panel 2 which can be removed.

The frame is constituted by a lower panel 3, an upper panel 4, two side panels 5, 6 and a back panel 7.

Some edges of the several panels present a L shaped bending for granting more stiffness to the unit and the panels are fixed to each other to form a unitary body, preferably by welding.

The several panels constitute a rectangular parallelepiped shaped housing, frontally opened, and their four edges define a front plane.

For illustrative purposes, it is particularly pointed out that lower panel 3 is double L bent in correspondence of the front panel in order to present a laying flange 3A on the front plane and an horizontal foot 3B extending perpendicularly to the front plane for the whole width of the frame.

Likewise upper panel 4, in correspondence of the front plane, presents a L shaped bending towards the external of the frame in order to obtain a laying flange 4A in the front plane.

Inside the housing the lower and upper panels bear a plurality of PWA tracks arranged parallel the one to the other and perpendicularly to the open frontal plane of the housing.

For sake of clarity only one of such tracks is designated with reference number 8.

Each track arranged on the lower panel corresponds to a track arranged on the upper panel in the same perpendicular plane.

Each of such track is provided with a guiding groove intended to contain a PWA edge.

In Fig. 1 the housing is, for instance, embodied with 8 lower tracks and 8 upper tracks, that is with 8 PWA locations and it can therefore contain up to 8 PWAs.

The several locations are identified in Fig. 1 by means of the upper tracks and are numbered from 11 to 18.

The PWAs are inserted into the housing through the front by inserting the upper and lower edges of the PWAs into the groove of an upper track and a corresponding lower track, respectively.

In Fig. 1 2 PWAs 9, 10 already inserted in the housing are shown.

The back panel 7 is generally provided with connection sockets not shown, vertically arranged and intended to obtain the electrical connection with the PWAs inserted in the housing.

The several PWAs constitutes a reconfigurable EDP system, where the PWA arranged for instance into locations 12, 14, 17, 18 must be present to constitute the basic system while locations 11, 13, 15, 16 may or may not contain PWAs to extend the system performances.

For instance a PWA acting as central unit or CPU can be arranged into location 12, a PWA acting as working memory or MM can be arranged into locations 14, two PWAs acting as controllers for peripheral units, such as disk units, can be arranged into locations 17, 18.

Some memory expansion PWAs can be optionally inserted into locations 11, 13 and PWAs acting as controllers of peripherals such as printers, connection terminals and transmission lines, etc., can be optionally inserted into locations 15, 16.

The system basic PWAs are inserted into the housing during the manufacturing process and are kept in the housing by a protection and stopping ruler 20.

Ruler 20 extends over the whole width of the rack housing and is fixed by screws 21, 22 to the flange 4A of upper panel 4.

Screws 21, 22 are inserted into opening 24, 25 of the ruler and screwed in correspondent threaded housings 26, 27 of flange 4A.

Screws 21, 22 are preferably tapered-head screws and opening 24, 25 are similarly tapered in order to house the heads of screws 21, 22 within ruler 20 thickness.

When ruler 20 is positioned, it partially closes the front opening of the housing in correspondence of the upper tracks by the extension of its lower edge downwards, beyond flange 4A.

In this way it prevents the extraction or the removal of the basic PWAs from the respective locations.

Ruler 20 presents some notches or undercuttings 28, 29, 30, 31 in correspondence of locations 11, 13, 16, 17 respectively, that is in correspondence of the reconfiguration and expansion PWA locations.

Such undercuttings allow the free PWA insertion or removal from the corresponding locations 11, 13, 16, 17 even if ruler 20 is fixed to the frame.

The frame opening is closed by a front panel 2 extending for the whole width and height of the frame and overlapping ruler 20.

Front panel 2 is fixed to the frame by means of knob screws 32, 33, 34 and by cogs 35, 36, 37, 38.

The screws are inserted into corresponding openings of the front panel and screwed in corresponding threaded frame housings 39, 40, 41 getting through suitable openings 42, 43, 44 of ruler 20.

Cogs 35, 36, 37, 38, arranged on the lower edge of panel 2, engage in corresponding housing in the laying flange 3B.

Housings 45, 46, 47 are shown in the figure.

When the front panel is fixed to the frame, it protects the PWAs arranged in the housing and prevents their removal irrespective of their location.

Front panel 2 presents suitable openings such as 48, 49, 50, 51, 52 to allow the insertion of connection plugs into connection sockets mounted on the front edge of the PWA.

One of such sockets is shown and designated with number 53 in Fig. 1. Such connectors enable the connection, by cable, to peripheral units of the system.

For instance, through opening 48 the connection of a control keyboard and of a display screen to the central unit PWA is enabled; through openings 49, 50 the connection is allowed to optional peripherals to the optional PWAs which may be arranged into locations 15, 16 and, through openings 51, 52 the connection is allowed of basic peripheral of the system to the control PWAs arranged in locations 17, 18.

With the disclosed rack housing the expansion or reconfiguration operation performed by the user is simple and safe.

The user can remove front panel 2 by unscrewing the screws 32, 33, 34 without using tool.

He can therefore insert additional PWAs (or substitute them) into the selected locations and only in those ones whose access is allowed by ruler 20, without the possibility of modificating the basic PWA arrangement.

Ruler undercuttings 28, 29, 30, 31 clearly display the several insertion positions and cut to the minimum the possible occurrence of mistakes.

It is clear that the front panel removal can require the extraction of possible connection plugs from their sockets which plugs must be inserted again at the end of the reconfigurating operation.

To minimize such operations, which may involve possible mistakes the front panel can be cut in two or more independent sections, each panel section assuring the protection and the retaining of a suitable group of PWAs.

For instance panel 2 of Fig. 1, can be cut into three sections 2A, 2B, 2C evidenced by hatched lines 54, 55.

So panel 2A assure the retaining and the protection of the group of PWAs arranged into locations 11, 12, 13, 14.

Panel 2B assures the retaining and the protection of the group of PWA arranged into locations 15, 16 and panel 2C assures the retaining and the protection of the group of PWAs arranged into locations 17, 18.

Therefore the insertion or the substitution of PWAs into locations 11, 13 only require the removal of panel 2A and the extension of one connector.

Likewise the insertion or the substitution of PWA into locations 15, 16 only requires the removal of panel 2B and of one connector.

It is to be noted that the use of a knob screw is not essential for the fixing of panel 2C as such panel protects some basic PWAs of the system.

It is also to be noted that panel 2C and more generally a plurality of panels protecting some basic PWAs of the system may constitute, together with ruler 20, a single unit.

The fixing means for ruler 20 and for the panels preferably suggested as tapered-head screws and knob screws, respectively, can clearly be substituted by equivalent fixing means provided they fundamentally differ for the ruler and for the panels and such as to require the use of different and more specialized tools for the ruler removal.

So, the knob screws preferred for the fixing of the panels can be substituted with slotted head screws which can be unscrewed and screwed by screwdrivers, coins or similar means.

In this case the fixing screws of the ruler could be of specialized kind, which can be unscrewed and screwed only by means of wrenches, crosshead screwdriver, square-head, hexagonal-head, star-head-keys, etc.

## Claims

1. Rack housing for user reconfigurable EDP system comprising:

— a frame having an open front to allow the insertion of a plurality of printed circuit boards each one in a rack position defined in said frame by a pair of tracks (11, 12, 13, 14, 15, 16, 17, 18),

— a protection bar (20) removably fixable with the aid of first tools to the open frame front and having an edge projecting on said open frame front in order to prevent the extraction from the frame of the printed circuit boards constituting a basic system configuration, said projecting edge being provided with cut-out portions (28, 29, 30, 31) selectively arranged along said edge to enable the extraction/insertion of additional printed circuit boards in selected rack positions, and

— at least one panel (2) covering the open front and being removably fixable without tools or with tools of a second type to the frame front in such a way that the protection bar is positioned between the frame and the panel or panels and cannot be removed without the previous removal of said panel.

2. Rack housing as in claim 1 wherein said protection bar is fixed to the open frame front by tapered head screws (21, 22) and said panel is fixed to the open frame front by knob screws (32, 33, 34) inserted through openings (42, 43, 44) in said protection bar.

## Patentansprüche

1. Gestellgehäuse für ein vom Benutzer rekonfigurierbares Datenverarbeitungssystem, gekennzeichnet durch

a) einen Rahmen mit offener Frontseite zum Einsetzen mehrerer Leiterplatten in Gestellpositionen, die im Rahmen jeweils durch zwei Schienen (11, 12, 13, 14, 15, 16, 17, 18) bestimmt sind;

b) eine Schutzleiste (20), die mit Hilfe eines ersten Werkzeugs abnehmbar an der offenen Frontseite des Rahmens befestigbar ist und eine in die Frontöffnung ragende Kante aufweist, welche das Entfernen von denjenigen Leiterplatten aus dem Rahmen verhindert, die die Basiskonfiguration des Systems bilden, und wobei diese Kante an vorgegebenen Stellen Ausnehmungen (28, 29, 30, 31) aufweist, welche das Einsetzen und Herausnehmen zusätzlicher Leiterplatten in bzw. aus ausgewählten Gestellpositionen gestattet;

c) wenigstens eine Frontplatte (2), welche die Frontöffnung abdeckt und entweder ohne Werkzeug oder mit einem vom ersten Werkzeug verschiedenen zweiten Werkzeug abnehmbar an der Rahmenfrontseite in solcher Weise befestigbar ist, daß die Schutzleiste zwischen dem Rahmen und der Frontplatte oder den Frontplatten angeordnet ist und ohne vorheriges Abnehmen der Frontplatte nicht entfernt werden kann.

2. Gestellgehäuse nach Anspruch 1, bei dem die Schutzleiste mit Kegelkopfschrauben (21, 22) an der Rahmenfrontseite befestigt ist und die Frontplatte durch Rändelschrauben (32, 33, 34) an der Rahmenfrontseite befestigbar ist, welche durch öffnungen (42, 43, 44) der Schutzleiste (20) hindurchragen.

## Revendications

1. Armoire de logement pour un système de traitement électronique de données EDP reconfigurable par l'utilisateur, comprenant:

— un bâti comportant une face avant ouverte pour permettre l'insertion d'un ensemble de plaquettes de circuits imprimés dont chacune se trouve à une position d'armoire définie dans le bâti par une paire de pistes (11, 12, 13, 14, 15, 16, 17, 18),

— une barre de protection (20) pouvant être fixée de façon amovible à l'aide de premiers outils à la face avant de bâti ouverte et comportant un bord dépassant de la face avant de bâti ouverte, afin d'empêcher l'extraction du bâti des plaquettes de circuits imprimés constituant une configuration de système de base, le bord saillant étant pourvu de parties évidées (28, 29, 30, 31) disposées sélectivement le long du bord pour permettre l'extraction/l'insertion de plaquettes de circuits imprimés supplémentaires aux positions d'armoire sélectionnées, et

— au moins un panneau (2) recouvrant la face avant ouverte et pouvant être fixé de façon amovible sans outils ou avec des outils d'un second type à la face avant de bâti de telle manière que la barre de protection est placée entre le bâti et le panneau ou les panneaux et qu'elle peut être retirée sans le retrait préalable du panneau.

2. Armoire de logement selon la revendication 1, dans laquelle la barre de protection est fixée à la face avant de bâti ouverte par des vis à tête conique (21, 22) et le panneau est fixé à la face avant de bâti ouverte par des vis à bouton (32, 33, 34) insérées par des trous (42, 43, 44) formés dans la barre de protection.

FIG. 1

0 156 298